# EUROPEAN PATENT APPLICATION

(11) **EP 4 582 523 A1**
(43) Date of publication of application: **09.07.2025**
(21) Application number: 23860208.0
(22) Date of filing: 25.08.2023
(51) Int. Cl.: C10M 169/04, C10M 101/02, C10M 125/08, C10M 125/10, C10M 125/20, C10M 125/26, C10N 10/04, C10N 10/06, C10N 10/08, C10N 10/10, C10N 10/12, C10N 20/00, C10N 20/02, C10N 30/00, C10N 40/00

(54) **LUBRICATING OIL COMPOSITION**

(30) Priority: 29.08.2022 JP 2022136306
(71) Applicant: Idemitsu Kosan Co.,Ltd., Tokyo 100-8321 (JP)
(72) Inventor: NAKAHARA, Yasuhito, Tokyo 100-8321 (JP); NARITA, Keiichi, Tokyo 100-8321 (JP)
(74) Representative: Vossius & Partner Patentanwälte Rechtsanwälte mbB
(86) International application number: PCT/JP2023/030705
(87) International publication number: WO 2024/048446

(57) **Abstract**

There has been a demand for a lubricating oil composition that has excellent cooling performance and insulating properties. This lubricating oil composition contains a base oil (A), solid particles (B) that have an average primary particle diameter of 500 nm or less, and a dispersant (C); the content of the solid particles (B) is 0.1 to 30% by mass based on the total amount of the lubricating oil composition; and the content of the dispersant (C) is 0.1 to 20% by mass based on the total amount of the lubricating oil composition.

## Description

### Technical Field

The present invention relates to a lubricating oil composition, a method for using and a method for producing the lubricating oil composition, and a cooling device.

### Background Art

In recent years, CO₂ reduction has been strongly demanded from the viewpoint of global environmental protection, and hence, efforts are being made to develop technology for fuel consumption efficiency in an automotive field. The mainstream technology in such fuel consumption efficiency includes hybrid vehicles and electric vehicles, and it is predicted that they will rapidly spread in the future. The hybrid vehicles and the electric vehicles have an electric motor and a generator, and in the case where cooling of them is carried out by an oil cooling method, existing automatic transmission fluid (ATF) and continuously variable transmission fluid (CVTF) are mainly used as lubricating oil compositions.

By these lubricating oil compositions, not only excellent cooling performance but also electrical insulation properties are demanded in order to maintain reliability for a long time in the aspect of insulation properties of an electric motor. As such a lubricating oil composition, for example, a cooling liquid containing a base liquid and porous fine particles having predetermined constitution is disclosed in Patent Literature 1.

### Citation List

### Patent Literature

Patent Literature 1: Japanese Patent Laid-Open No. 2021-113242

### Summary of Invention

### Technical Problem

In such a situation, a lubricating oil composition is demanded which is excellent in cooling performance and insulation properties.

### Solution to Problem

As a result of exhaustive studies, the present inventors have found that the above problem can be solved by a lubricating oil composition in which specific amounts of solid particles having an average primary particle diameter of 500 nm or less and a dispersant are contained in a base oil, and have completed the present invention.

That is, the present invention provides the following aspects [1] to [15].
[1] A lubricating oil composition comprising a base oil (A), solid particles (B) having an average primary particle diameter of 500 nm or less, and a dispersant (C), wherein a content of the solid particles (B) is 0.1 to 30 mass% based on a total amount of the lubricating oil composition, and a content of the dispersant (C) is 0.1 to 20 mass% based on the total amount of the lubricating oil composition.
[2] The lubricating oil composition according to [1], wherein a content ratio [(B)/(C)] in terms of mass ratio between the solid particles (B) and the dispersant (C) is 0.05 or more and less than 3.
[3] The lubricating oil composition according to [1] or [2], wherein the average primary particle diameter of the solid particles (B) is 100 nm or less.
[4] The lubricating oil composition according to any one of [1] to [3], wherein the solid particles (B) are selected from the group consisting of SiO₂, Al₂O₃, AlN, TiO₂, ZrO₂, Y₂O₃, WO₃, Ta₂O₅, V₂O₅, Nb₂O₅, CeO₂, B₄C, Al₂TiO₅, BN, MoSi₂, SiC, Si₃N₄, TiC, TiN, ZrB₂, CaO, SrO, BaO, clay minerals, mixtures thereof, and thermally stable carbonates or sulfates thereof.
[5] The lubricating oil composition according to any one of [1] to [4], wherein the base oil (A) comprises at least a mineral oil (A1).
[6] The lubricating oil composition according to any one of [1] to [5], wherein the base oil (A) has a kinematic viscosity at 40°C of 10 mm²/s or less.
[7] The lubricating oil composition according to any one of [1] to [6], wherein the base oil (A) has a volume resistivity of 8.0×10¹⁰ Ω·m or more.
[8] The lubricating oil composition according to any one of [1] to [7], wherein the lubricating oil composition is substantially free of water.
[9] The lubricating oil composition according to any one of [1] to [8], wherein the lubricating oil composition has a kinematic viscosity at 40°C of 20 mm²/s or less.
[10] The lubricating oil composition according to any one of [1] to [9], wherein the lubricating oil composition has a volume resistivity of 1.0×10⁸ Ω·m or more.
[11] The lubricating oil composition according to any one of [1] to [10], wherein the lubricating oil composition is used for cooling an electrical apparatus.
[12] The lubricating oil composition according to [11], wherein the electrical apparatus is a motor, a battery, an inverter, and an engine.
[13] A cooling device for cooling an electrical apparatus, comprising the lubricating oil composition according to any one of [1] to [12] filled therein.
[14] A method for using a lubricating oil composition, wherein the lubricating oil composition according to any one of [1] to [12] is applied to cooling of an electrical apparatus.
[15] A method for producing the lubricating oil composition according to any one of [1] to [12], comprising a step of stirring at 10,000 rpm or more.

### Advantageous Effects of Invention

The suitable lubricating oil composition according to one aspect of the present invention has excellent cooling performance and insulation properties. Hence, the lubricating oil composition according to one aspect of the present invention can be used suitably for cooling electrical apparatuses.

### Description of Embodiments

With regard to numerical value ranges described in the present description, an upper limit value and a lower limit value can optionally be paired. For example, in the case where there is a description of "preferably 30 to 100, more preferably 40 to 80" as a numerical value range, a range of "30 to 80" and a range of "40 to 100" also are included in the numerical value range described in the present description. Further, for example, in the case where there is a description of "preferably 30 or more, more preferably 40 or more and preferably 100 or less, more preferably 80 or less", as a numerical value range described in the present description, a range of "30 to 80" and a range of "40 to 100" also are included in the numerical value range described in the present description.

Additionally, for example, a description of "60 to 100" as a numerical value range described in the present description means a range of "60 or more and 100 or less".

Further, in a prescription of an upper limit value and a lower limit value described in the present description, the numerical value range of from a lower limit value to an upper limit value can be prescribed by suitably selecting and optionally pairing the lower limit value and the upper limit value from among respective options.

Additionally, a plurality of various requirements to be described as preferred embodiments in the present description can be combined.

### [Constitution of the lubricating oil composition]

One embodiment of the present invention is a lubricating oil composition comprising a base oil (A) (also referred to as a "component (A)" hereinafter), solid particles (B) having an average primary particle diameter of 500 nm or less (also referred to as a "component (B)" hereinafter), and a dispersant (C) (also referred to as a "component (C)" hereinafter), wherein a content of the solid particles (B) is 0.1 to 30 mass% based on the total amount of the lubricating oil composition, and a content of the dispersant (C) is 0.1 to 20 mass% based on the total amount of the lubricating oil composition.

From the viewpoint of enhancing insulation properties, it is preferable to blend the base oil (A) in the lubricating oil composition to be used for cooling electrical apparatuses. On the other hand, by the lubricating oil composition containing the base oil (A) blended therein, improvement in cooling performance has also been demanded. Although a lubricating oil composition containing solid particles (B) can improve cooling performance, it is necessary to add a dispersant in order to homogeneously disperse the solid particles (B). However, if the amount of the dispersant increases, the viscosity of the lubricating oil composition tends to increase, and it is difficult to adjust the viscosity of the lubricating oil composition within an appropriate range while exhibiting excellent cooling performance.

The present inventors have found that in order to solve such a problem, by adjusting the contents of the component (B) and the component (C) within their respective predetermined ranges, a lubricating oil composition a viscosity of which is kept low and which can exhibit excellent cooling performance and insulation properties can be made, and this finding has led to the completion of the present invention.

The kinematic viscosity at 40°C of the lubricating oil composition according to one embodiment of the present invention is preferably 20 mm²/s or less, more preferably 19 mm²/s or less, still more preferably 18 mm²/s or less, further still more preferably 17 mm²/s or less, further still more preferably 16 mm²/s or less and especially preferably 15 mm²/s or less.

The viscosity index of the lubricating oil composition according to one embodiment of the present invention is preferably 70 or more, more preferably 80 or more, still more preferably 90 or more and further still more preferably 100 or more.

The lubricating oil composition according to one embodiment of the present invention is substantially free of water. "Being substantially free of water" means to exclude a lubricating oil composition in which water and a mixed solvent containing water have been intentionally blended. However, an embodiment in which water has been inevitably mixed is not even excluded from the lubricating oil composition according to one embodiment of the present invention, but from the viewpoint of obtaining a lubricating oil composition having high insulation properties, the content of such water is preferably as small as possible.

Specifically, the content of water inevitably mixed is, based on the total amount (100 mass%) of the lubricating oil composition, preferably less than 0.05 mass%, more preferably less than 0.03 mass%, still more preferably less than 0.01 mass% and especially preferably less than 0.001 mass%.

The lubricating oil composition according to one embodiment of the present invention may further comprise additives for lubricating oils other than the components (B) and (C).

In the lubricating oil composition according to one embodiment of the present invention, the total content of the components (A) and (B) is, based on the total amount (100 mass%) of the lubricating oil composition, preferably 50 mass% or more, more preferably 60 mass% or more, more preferably 70 mass% or more, still more preferably 80 mass% or more and especially preferably 90 mass% or more, and may be 100 mass% or less, 99.0 mass% or less, 98.0 mass% or less, 97.0 mass% or less, 96.0 mass% or less, or 95.0 mass% or less.

In the lubricating oil composition according to one embodiment of the present invention, the total content of the components (A) and (C) is, based on the total amount (100 mass%) of the lubricating oil composition, preferably 50 mass% or more, more preferably 60 mass% or more, more preferably 70 mass% or more, still more preferably 80 mass% or more and especially preferably 90 mass% or more, and may be 100 mass% or less, 99.5 mass% or less, or 99.0 mass% or less.

In the lubricating oil composition according to one embodiment of the present invention, the total content of the components (B) and (C) is, based on the total amount (100 mass%) of the lubricating oil composition, preferably 0.2 mass% or more, more preferably 0.5 mass% or more, still more preferably 1.0 mass% or more, further still more preferably 3.0 mass% or more, further still more preferably 5.0 mass% or more, further still more preferably 8.0 mass% or more and especially preferably 10 mass% or more, and then preferably 50 mass% or less, more preferably 45 mass% or less, still more preferably 40 mass% or less, further still more preferably 35 mass% or less, further still more preferably 30 mass% or less, further still more preferably 25 mass% or less and especially preferably 20 mass% or less.

Hereinafter, the detail of each component contained in a lubricating oil composition according to one embodiment of the present invention will be described.

### <Base oil (A)>

A base oil contained in the lubricating oil composition according to one embodiment of the present invention may be a mineral oil, may be a synthetic oil, or may be a mixed oil of a mineral oil and a synthetic oil.

Examples of the mineral oil include atmospheric residual oil obtained by atmospherically distilling crude oil such as paraffinic crude, intermediate-base crude or naphthenic crude; distillate oil obtained by vacuum distilling these atmospheric residual oils; refined oil obtained by subjecting the distillate oil to one or more refining treatments of solvent deasphalting, solvent extraction, hydrocracking, solvent dewaxing, catalytic dewaxing, hydrotreating and the like; and the like.

Examples of the synthetic oil include poly-α-olefins such as α-olefins and homopolymers thereof, and α-olefin copolymers (for example, α-olefin copolymers having 8 to 14 carbon atoms, such as ethylene-α-olefin copolymers); isoparaffin; monoester oils such as phosphate monoesters; ether oils such as polyphenyl ethers; alkylbenzenes; alkylnaphthalenes; synthetic oils (GTL) obtained by isomerizing waxes (GTL waxes (Gas To Liquids WAX)) produced from natural gas by the Fischer-Tropsch process; synthetic oils (CTL) obtained by isomerizing waxes (CTL waxes (Coal To Liquids WAX)) produced from coal by the Fischer-Tropsch process; and synthetic oils (BTL) obtained by isomerizing waxes (BTL waxes (Biomass To Liquids WAX)) produced from biomass by the Fischer-Tropsch process.

Among these, the base oil to be used in one embodiment of the present invention preferably contains at least one selected from mineral oils and synthetic oils classified into Group 2 and Group 3 in the API (American Petroleum Institute) base oil category. In one embodiment of the present invention, these base oils may be used singly in one kind, or may be used concurrently in two or more kinds.

From the viewpoint of obtaining a lubricating oil composition having high insulation properties, the lubricating oil composition according to one embodiment of the present invention preferably contains at least a mineral oil (A1). From the same viewpoint as above, the lubricating oil composition according to another embodiment of the present invention preferably contains a mixed base oil of the mineral oil (A1) and one or more synthetic oils (A2) selected from the group consisting of naphthenic oils, poly-α-olefins, aromatic oils, and ether oils, and as the synthetic oil (A2), naphthenic oils and poly-α-olefins are more preferable.

From the viewpoint of obtaining a lubricating oil composition having high insulation properties, it is preferable for the lubricating oil composition according to a further embodiment of the present invention to be substantially free of a highly polar component as the base oil (A). Specifically, it is preferable to be substantially free of, for example, alcohols (primary alcohols, secondary alcohols, tertiary alcohols and the like) or ester compounds (diester compounds, triester compounds and the like) other than monoester compounds. "Being substantially free of alcohols or ester compounds other than monoester compounds" means to exclude a lubricating oil composition in which these have been intentionally blended, and an embodiment in which these have been inevitably mixed is not even excluded, but from the same viewpoint as above, the content of such alcohols or ester compounds other than monoester compounds is preferably as small as possible.

Specifically, the content of the alcohols or the ester compounds other than monoester compounds inevitably mixed is, based on the total amount (100 mass%) of the lubricating oil composition, preferably less than 0.05 mass%, more preferably less than 0.03 mass%, still more preferably less than 0.01 mass% and especially preferably less than 0.001 mass%.

The lubricating oil composition according to one embodiment of the present invention may contain a monoester compound as the base oil (A).

From the viewpoint of obtaining a lubricating oil composition having high insulation properties, it is preferable for the lubricating oil composition according to one embodiment of the present invention to be substantially free of vegetable oils such as soybean oil, palm oil, palm kernel oil, sunflower oil and rapeseed oil, as the base oil (A). "Being substantially free of vegetable oils" means to exclude a lubricating oil composition in which these have been intentionally blended, and an embodiment in which these have been inevitably mixed is not even excluded, but from the same viewpoint as above, the content of such vegetable oils is preferably as small as possible.

Specifically, the content of the vegetable oils inevitably mixed is, based on the total amount (100 mass%) of the lubricating oil composition, preferably less than 0.05 mass%, more preferably less than 0.03 mass%, still more preferably less than 0.01 mass% and especially preferably less than 0.001 mass%.

From the viewpoint of obtaining a lubricating oil composition having high insulation properties, in the lubricating oil composition according to one embodiment of the present invention, the content of alcohols or the ester compounds other than monoester compounds is, based on 100 parts by mass of the mineral oil (A1), preferably 0 to 0.1 part by mass, more preferably 0 to 0.01 part by mass and still more preferably 0 to 0.001 part by mass.

From the viewpoint of obtaining a lubricating oil composition having high insulation properties, in the lubricating oil composition according to another embodiment of the present invention, the content of alcohols or the ester compounds is, based on 100 parts by mass of the mineral oil (A1), preferably 0 to 0.1 part by mass, more preferably 0 to 0.01 part by mass and still more preferably 0 to 0.001 part by mass.

From the viewpoint of obtaining a lubricating oil composition having high insulation properties, in the lubricating oil composition according to a further embodiment of the present invention, the content of the vegetable oils is, based on 100 parts by mass of the mineral oil (A1), preferably 0 to 0.1 part by mass, more preferably 0 to 0.01 part by mass and still more preferably 0 to 0.001 part by mass.

The kinematic viscosity at 40°C of the base oil (A) to be used in one embodiment of the present invention is preferably 10 mm²/s or less, more preferably 9.5 mm²/s or less, still more preferably 9.0 mm²/s or less and especially preferably 8.5 mm²/s or less, and then preferably 1.0 mm²/s or more, more preferably 2.0 mm²/s or more, still more preferably 2.5 mm²/s or more and further still more preferably 3.0 mm²/s or more. When the viscosity at 40°C of the base oil is 10 mm²/s or less, it is preferable because the viscosity of the lubricating oil composition can be kept low and high cooling performance is obtained. On the other hand, when the viscosity at 40°C of the base oil is 1.00 mm²/s or more, it is preferable for retaining oil films.

The viscosity index of the base oil (A) to be used in one embodiment of the present invention is, from the viewpoint of suppressing the viscosity change by the temperature change, and improving the cooling performance, preferably 70 or more, more preferably 80 or more, still more preferably 90 or more and further still more preferably 100 or more.

In the present description, the kinematic viscosity and the viscosity index mean values measured or calculated according to JIS K2283:2000.

The volume resistivity of the base oil (A) to be used in one embodiment of the present invention is preferably 8.0×10¹⁰ Ω·m or more, more preferably 1.0×10¹¹ Ω·m or more, still more preferably 1.0×10¹² Ω·m or more, further still more preferably 5.0×10¹² Ω·m or more and especially preferably 15x10¹² Ω·m or more. When the volume resistivity of the base oil (A) is 8.0×10¹⁰ Ω·m or more, a lubricating oil composition having high insulation properties can be obtained. In the present description, the volume resistivity is one measured under the condition of a measurement temperature of 80°C and an applied voltage of 250 V according to JIS C2101.

In the lubricating oil composition according to one embodiment of the present invention, the content of the base oil (A) is, based on the total amount (100 mass%) of the lubricating oil composition, usually 55 mass% or more, preferably 60 mass% or more, more preferably 65 mass% or more, still more preferably 70 mass% or more, further still more preferably 75 mass% or more and especially preferably 80 mass% or more, and then preferably 99.9 mass% or less, more preferably 98 mass% or less and still more preferably 95 mass% or less.

### <Solid particles (B)>

The lubricating oil composition according to one embodiment of the present invention comprises solid particles (B) having an average primary particle diameter of 500 nm or less. The lubricating oil composition can be improved in cooling performance by containing the solid particles (B).

Examples of the solid particles (B) include silicon dioxide (SiO₂), aluminum oxide (Al₂O₃), aluminum nitride (AlN), titanium oxide (TiO₂), zirconium oxide (ZrO₂), yttrium oxide (Y₂O₃), tungsten oxide (WO₃), tantalum pentoxide (Ta₂O₅), vanadium pentoxide (V₂O₅), niobium pentoxide (Nb₂O₅), cerium oxide (CeO₂), boron carbide (B₄C), aluminum titanate (Al₂TiO₅), boron nitride (BN), molybdenum disilicide (MoSi₂), silicon carbide (SiC), silicon nitride (Si₃N₄), titanium carbide (TiC), titanium nitride (TiN), zirconium boride (ZrB₂), calcium oxide (CaO), strontium oxide (SrO), barium oxide (BaO), and clay minerals. The solid particles (B) may be mixtures or thermally stable carbonates or sulfates of those mentioned above. Among them, silicon dioxide is especially preferable as the solid particles (B).

In one embodiment of the present invention, these solid particles may be used singly in one kind, or may be used concurrently in two or more kinds.

The average primary particle diameter of the solid particles (B) to be used in one embodiment of the present invention is 500 nm or less, but from the viewpoint of improving dispersibility of the solid particles (B) and obtaining a lubricating oil composition having high cooling performance, it is preferably 400 nm or less, more preferably 300 nm or less, still more preferably 200 nm or less and especially preferably 100 nm or less, or may be 90 nm or less, 80 nm or less, 70 nm or less, 60 nm or less, 50 nm or less, 40 nm or less, 30 nm or less, 20 nm or less, or 10 nm or less. The lower limit of the average primary particle diameter of the solid particles (B) is not especially limited, but may be, for example, 1 nm or more, 3 nm or more, or 5 nm or more.

In the present description, the average primary particle diameter of the solid particles (B) means a value obtained by calculating an average value of equivalent circle diameters of 100 or more primary particles selected at random using a scanning electron microscope (SEM). The solid particles (B) may form secondary particles or may not form secondary particles.

The solid particles (B) to be used in one embodiment of the present invention may have been subjected to surface treatment with a surface treatment agent, or may not have been subjected to surface treatment. By using solid particles having been subjected to surface treatment, dispersibility of the solid particles is more improved, and a lubricating oil composition having high cooling performance can be obtained. Examples of the surface treatment agent include a silane coupling agent and a silicone oil.

Examples of the silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-mercaptopropylmethyldimethoxysilane, 3-mercaptopropyltrimethoxysilane, 3-isocyanatopropyltriethoxysilane and 3-trimethoxysilylpropylsuccinic anhydride.

Examples of the silicone oil include so-called straight silicone oils such as dimethylpolysiloxane, methylphenylpolysiloxane and methylhydrogenpolysiloxane; and so-called modified silicone oils such as polyether-modified polysiloxane, amino-modified polysiloxane, epoxy-modified polysiloxane, polyether-modified polysiloxane, phenol-modified polysiloxane, carboxy-modified polysiloxane, mercapto-modified polysiloxane, acrylic-modified polysiloxane, methacrylic-modified polysiloxane and alkyl-modified polysiloxane.

As the solid particles (B1) to be used in one embodiment of the present invention, porous ones having pores (porous) on the surface may be used, or non-porous ones having no pores may be used. In the lubricating oil composition according to one embodiment of the present invention, non-porous solid particles (B) are preferably used from the viewpoint of obtaining a lubricating oil composition having high cooling performance.

In the lubricating oil composition according to one embodiment of the present invention, the content of the solid particles (B) is, based on the total amount (100 mass%) of the lubricating oil composition, 0.1 to 30 mass%, but from the viewpoint of obtaining a lubricating oil composition having high cooling performance, it is preferably 0.5 mass% or more, more preferably 1.0 mass% or more, still more preferably 3.0 mass% or more, further still more preferably 5.0 mass% or more and especially preferably 10 mass% or more, and from the viewpoint of improving dispersibility of the solid particles (B), it is preferably 25 mass% or less, more preferably 20 mass% or less, still more preferably 18 mass% or less and especially preferably 15 mass% or less.

The content of the solid particles (B) means a content in terms of solid content. In the case where solid particles having been subjected to surface treatment are used, the amount of the surface treatment agent is also included in the content of the solid particles (B).

### <Dispersant (C)>

The lubricating oil composition according to one embodiment of the present invention comprises a dispersant (C). By containing the dispersant (C), the solid particles (B) can be homogeneously dispersed in the lubricating oil composition, and a lubricating oil composition having high cooling performance can be obtained.

Examples of the dispersant (C) that can be used include ashless dispersants such as a succinic acid imide-based dispersant, a vinylpyrrolidone (VP)/hexadecene copolymer, benzylamines, boron-containing benzylamines, succinic acid esters, fatty acids, and monovalent or divalent carboxylic acid amides represented by succinic acid. Among these, a succinic acid imide-based dispersant or a VP/hexadecene copolymer is preferable.

The succinic acid imide-based dispersant is preferably an alkenyl succinic acid imide, and may also be a modified alkenyl succinic acid imide made by reacting an alkenyl succinic acid imide with at least one selected from boron compounds, alcohols, aldehydes, ketones, alkylphenols, cyclic carbonates, epoxy compounds, organic acids and the like.

In one embodiment of the present invention, these dispersants may be used singly in one kind, or may be used concurrently in two or more kinds.

In the lubricating oil composition according to one embodiment of the present invention, the content of the dispersant (C) is, based on the total amount (100 mass%) of the lubricating oil composition, 0.1 to 20 mass%, but from the viewpoint of improving dispersibility of the solid particles, it is preferably 0.5 mass% or more, more preferably 1.0 mass% or more, still more preferably 1.5 mass% or more and especially preferably 2.0 mass% or more, and from the viewpoint of keeping the viscosity of the lubricating oil composition low, it is preferably 20 mass% or less, more preferably 15 mass% or less, still more preferably 12 mass% or less and further still more preferably 10 mass% or less.

The content of the dispersant (C) means a content in terms of solid content.

In the lubricating oil composition according to one embodiment of the present invention, the content ratio [(B)/(C)] in terms of mass ratio between the solid particles (B) and the dispersant (C) is 0.05 or more and less than 3, but from the viewpoint of improving dispersibility of the solid particles (B), it is preferably 0.06 or more, more preferably 0.07 or more, still more preferably 0.08 or more, further still more preferably 0.09 or more and especially preferably 0.1 or more, and then from the viewpoint of improving cooling performance and keeping the viscosity of the lubricating oil composition low, it is preferably 3 or less, more preferably 2.5 or less, still more preferably 2 or less, further still more preferably 1.5 or less and especially preferably 1 or less.

### <Various kinds of additives>

The lubricating oil composition according to one embodiment of the present invention may comprise various kinds of additives in the range of not impairing the advantageous effects of the present invention.

Examples of such various kinds of additives include viscosity index improver, pour point depressants, antioxidants, metallic detergents, antiwear agents, rust inhibitors, deformers and extreme pressure additives.

These additives for lubricating oils may be used singly, or may be used concurrently in two or more kinds.

Each content of these various kinds of additives can be suitably adjusted in the range of not impairing the advantageous effects of the present invention, but is, based on the total amount (100 mass%) of the lubricating oil composition, independently, usually 0.001 to 15 mass%, preferably 0.005 to 10 mass% and more preferably 0.01 to 5 mass%.

As additives, there may be used a commercially available additive package containing a plurality of additives.

Further, there may be used a compound (for example, a compound having functions as an antiwear agent and an extreme pressure additive) having multiple functions as the above additives.

These additives for lubricating oils may be used singly or may be used concurrently in two or more kinds.

### [Viscosity index improver]

The lubricating oil composition according to one embodiment of the present invention may further comprise a viscosity index improver. The viscosity index improver may be used singly or may be used concurrently in two or more kinds.

Examples of the viscosity index improver to be used in one embodiment of the present invention include polymethacrylate, dispersed polymethacrylate, olefin copolymers (for example, ethylene-propylene copolymers), dispersed olefin copolymers, and styrene copolymers (for example, styrene-diene copolymers and styrene-isoprene copolymers).

### [Pour point depressant]

The lubricating oil composition according to one embodiment of the present invention may further comprise a pour point depressant. The pour point depressant may be used singly or may be used concurrently in two or more kinds.

Examples of the pour point depressant to be used in one embodiment of the present invention include ethylenevinyl acetate copolymers, condensates of chlorinated paraffin with naphthalene, condensates of chlorinated paraffin with phenol, polymethacrylates and polyalkylstyrenes.

### [Antioxidant]

The lubricating oil composition according to one embodiment of the present invention may further comprise an antioxidant. The antioxidant may be used singly or may be used concurrently in two or more kinds.

Examples of the antioxidant to be used in one embodiment of the present invention include amine antioxidants such as alkylated diphenylamines, phenylnaphthylamine and alkylated phenylnaphthylamine; phenol antioxidants such as 2,6-di-t-butylphenol, 4,4'-methylenebis(2,6-di-t-butylphenol), isooctyl-3-(3,5-di-t-butyl-4-hydroxyphenyl) propionate, and n-octadecyl-3-(3,5-di-t-butyl-4-hydroxyphenyl) propionate; sulfur antioxidants such as phenothiazine, dioctadecyl sulfide, dilauryl-3,3'-thiodipropionate and 2-mercaptobenzimidazole; and the like.

### [Metallic detergent]

The lubricating oil composition according to one embodiment of the present invention may further comprise a metallic detergent. The metallic detergent may be used singly or may be used concurrently in two or more kinds.

The metallic detergent to be used in one embodiment of the present invention includes metal salts such as metal sulfonates, metal salicylates and metal phenates. Then, a metal atom constituting the metal salt is preferably a metal atom selected from alkali metals and alkaline earth metals, more preferably sodium, calcium, magnesium or barium, and still more preferably calcium.

### [Antiwear agent]

The lubricating oil composition according to one embodiment of the present invention may further comprise an antiwear agent. The antiwear agent may be used singly or may be used concurrently in two or more kinds.

Examples of the antiwear agent to be used in one embodiment of the present invention include sulfur- or phosphorus-containing antiwear agents including sulfur-containing compounds such as zinc dialkyldithiophosphate (ZnDTP), zinc phosphate, zinc dithiocarbamate, molybdenum dithiocarbamate, molybdenum dithiophosphate, disulfides, olefin sulfides, sulfurized fats and oils, sulfurized esters, thiocarbonates, thiocarbamates and polysulfides; phosphorus-containing compounds such as phosphite esters, phosphate esters, phosphonate esters, and amine salts or metal salts thereof; and thiophosphite esters, thiophosphate esters, thiophosphonate esters, and amine salts or metal salts thereof.

### [Rust inhibitor]

The lubricating oil composition according to one embodiment of the present invention may further comprise a rust inhibitor. The rust inhibitor may be used singly or may be used concurrently in two or more kinds.

Examples of the rust inhibitor to be used in one embodiment of the present invention include fatty acids, alkenyl succinic acid half esters, fatty acid soaps, alkylsulfonate salts, polyhydric alcohol fatty acid esters, fatty acid amines, oxidized paraffins and alkyl polyoxyethylene ethers.

### [Defoamer]

The lubricating oil composition according to one embodiment of the present invention may further comprise a defoamer. The defoamer may be used singly or may be used concurrently in two or more kinds.

Examples of the defoamer to be used in one embodiment of the present invention include alkylsilicone defoamers, fluorosilicone defoamers and fluoroalkyl ether defoamers.

### [Extreme pressure additive]

The lubricating oil composition according to one embodiment of the present invention may further comprise an extreme pressure additive. The extreme pressure additive may be used singly or may be used concurrently in two or more kinds.

Examples of the extreme pressure additive to be used in one embodiment of the present invention include chlorine extreme pressure additives such as chlorinated paraffins, chlorinated fatty acids and chlorinated fatty oils; sulfur extreme pressure additives such as sulfurized olefins, sulfurized lard, alkyl polysulfides and sulfurized fatty acids; phosphorus extreme pressure additives such as phosphate esters, phosphite esters, thiophosphate esters, and salts thereof, phosphine ones and tricresyl phosphate; and the like.

### <Method for producing the lubricating oil composition>

The method for producing a lubricating oil composition according to one embodiment of the present invention preferably comprises a step of stirring the composition containing the base oil (A), the solid particles (B) and the dispersant (C) at 10,000 rpm or more. By the step, the solid particles (B) can be homogeneously dispersed in the lubricating oil composition. In the step, the stirring speed may be 12,000 rpm or more, 15,000 rpm or more, 17,000 rpm or more, or 20,000 rpm or more.

The method for producing a lubricating oil composition according to one embodiment of the present invention preferably comprises a step of blending other various additives in addition to the components (A) to (C) mentioned above, as needed. The order of blending each component can suitably be established.

### [Properties of the lubricating oil composition]

The kinematic viscosity at 100°C of the lubricating oil composition according to one embodiment of the present invention is preferably 0.8 mm²/s or more, more preferably 1.0 mm²/s or more and still more preferably 1.2 mm²/s or more, and preferably 4.0 mm²/s or less, more preferably 3.5 mm²/s or less and still more preferably 3.0 mm²/s or less.

The volume resistivity of the lubricating oil composition according to one embodiment of the present invention is preferably 1.0×10⁸ Ω·m or more, more preferably 1.3×10⁸ Ω·m or more, still more preferably 1.5×10⁸ Ω·m or more, further still more preferably 2.0x10⁸ Ω·m or more and especially preferably 2.1×10⁸ Ω·m or more.

The cooling performance of the lubricating oil composition according to one embodiment of the present invention is preferably 20.0°C/sec or more, more preferably 22.0°C/sec or more, still more preferably 23.0°C/sec or more and especially preferably 25.0°C/sec or more. In the present description, the cooling performance means a value for a maximum cooling rate (°C/sec) within 12 seconds from the start of submerging in oil when a silver bar having been heated to 200°C is submerged in oil having been controlled to 30°C according to JIS K2242.

### [Applications of the lubricating oil composition]

The lubricating oil composition of the present invention has excellent cooling performance and insulation properties. Hence, the lubricating oil composition of the present invention can be used suitably for cooling electrical apparatuses. Examples of the electrical apparatuses include a motor, a battery, an inverter, and an engine.

Hence, the present invention also provides a cooling device of the following [I] and a method for using a lubricating oil composition of the following [II].
[I] A cooling device for cooling electrical apparatuses, comprising the above-mentioned lubricating oil composition according to one embodiment of the present invention filled therein.
[II] A method for using a lubricating oil composition, wherein the above-mentioned lubricating oil composition according to one embodiment of the present invention is applied to cooling of an electrical apparatus.

### Examples

Then, the present invention will be described in more detail by way of Examples, but the present invention is not any more limited to these Examples. Here, various physical properties of each component used in Examples, Comparative Examples and Reference Example and obtained lubricating oil compositions were measured according to the following methods.

### <Kinematic viscosity, viscosity index>

The kinematic viscosity and the viscosity index are measured and calculated according to JIS K2283:2000.

### <Cooling performance>

When a silver bar having been heated to 200°C was submerged in oil having been controlled to 30°C, a maximum cooling rate (°C/sec) within 12 seconds from the start of submerging in oil was measured according to JIS K2242.

### <Volume resistivity>

The volume resistivity was measured under the condition of a measurement temperature of 80°C and an applied voltage of 250 V according to JIS C2101.

### Examples 1 to 5 and Comparative Examples 1 to 3

The components (A) to (C) indicated in Table 1 were added and mixed in blend amounts indicated in Table 1, and they were stirred at 20,000 rpm for 5 minutes using a homogenizer to thereby prepare lubricating oil compositions, respectively. The lubricating oil compositions prepared was substantially free of water. The detail of each component used in preparation of the lubricating oil compositions were as follows.

### <Base oil (A)>

- Mineral oil: a mineral oil classified in Group II of the API base oil category, having a 40°C kinematic viscosity of 8.2 mm²/s and a viscosity index of 103, and having a volume resistivity of 18×10¹² Ω·m.

### <Solid particles (B)>

- SiO₂: silica particles having an average primary particle diameter of 10 nm and having been surface-treated with silicone oil.

### <Dispersant (C)>

- Succinic acid imide (non-boron modified alkenyl succinic acid bisimide, content of nitrogen atom = 1.80 mass%)
- Vinylpyrrolidone (VP)/hexadecene copolymer

For the lubricating oil compositions prepared in Examples and Comparative Examples, the various physical properties were measured and calculated according to the above-mentioned measurement methods. The results thereof are shown in Table 1. In Table 1, with regard to the "dispersibility", after each sample prepared was allowed to stand for 1 week, presence of precipitation was visually confirmed, and a sample in which precipitation had not been confirmed was evaluated as "A", and a sample in which precipitation had been confirmed was evaluated as "F". The 40°C kinematic viscosity of the lubricating oil composition of each Example, as measured and calculated according to the above-mentioned measurement method, is 20 mm²/s or less, and the viscosity index thereof is 70 or more.

[Table 1]

**Table 1**

| Composition of lubricating oil composition | | | Example 1 | Example 2 | Example 3 | Example 4 | Example 5 | Comparative Example 1 | Comparative Example 2 | Comparative Example 3 |
|---|---|---|---|---|---|---|---|---|---|---|
| (A) Base oil | Mineral oil (60N) | mass% | 85 | 90 | 80 | 89 | 85 | 90 | 95 | |
| | Water | mass% | | | | | | | | 95 |
| (B) Solid particles | SiO₂ | mass% | 5.0 | 5.0 | 10 | 1.0 | 5.0 | | 5.0 | 5.0 |
| (C) Dispersant | Succinic acid imide | mass% | 10 | 5.0 | 10 | 10 | | 10 | | |
| | VP/hexadecene copolymer | mass% | | | | | 10 | | | |
| Total | | mass% | 100 | 100 | 100 | 100 | 100 | 100 | 100 | 100 |
| Content ratio (mass ratio) of solid particles (B)/dispersant (C) | | - | 0.5 | 1.0 | 1.0 | 0.1 | 0.5 | - | - | - |
| Properties of lubricating oil composition | | | | | | | | | | |
| Cooling performance | | °C/sec | 27.5 | 27.8 | 27.8 | 20.8 | 25.4 | 19.3 | - | - |
| Dispersibility | | - | A | A | A | A | A | A | F | F |
| Volume resistivity | | Ω·m | 2.1x10⁸ | 2.1x10⁸ | 2.1x10⁸ | 2.1x10⁸ | 1.3x10⁸ | 2.1x10⁸ | - | - |

From Table 1, it is shown that the lubricating oil compositions of Examples 1 to 5 containing the base oil (A) and having contents of the solid particles (B) and the dispersant (C) in predetermined numerical value ranges had excellent cooling performance and insulation properties and also had good dispersibility of the solid particles (B), as compared with Comparative Examples 1 to 3.

## Claims

1. A lubricating oil composition, comprising:
a base oil (A);
solid particles (B) having an average primary particle diameter of 500 nm or less; and
a dispersant (C), wherein
a content of the solid particles (B) is 0.1 to 30 mass% based on a total amount of the lubricating oil composition; and
a content of the dispersant (C) is 0.1 to 20 mass% based on the total amount of the lubricating oil composition.

2. The lubricating oil composition according to claim 1, wherein a content ratio [(B)/(C)] in terms of mass ratio between the solid particles (B) and the dispersant (C) is 0.05 or more and less than 3.

3. The lubricating oil composition according to claim 1 or 2, wherein the average primary particle diameter of the solid particles (B) is 100 nm or less.

4. The lubricating oil composition according to any one of claims 1 to 3, wherein the solid particles (B) are selected from the group consisting of SiO₂, Al₂O₃, AlN, TiO₂, ZrO₂, Y₂O₃, WO₃, Ta₂O₅, V₂O₅, Nb₂O₅, CeO₂, B₄C, Al₂TiO₅, BN, MoSi₂, SiC, Si₃N₄, TiC, TiN, ZrB₂, CaO, SrO, BaO, clay minerals, mixtures thereof, and thermally stable carbonates or sulfates thereof.

5. The lubricating oil composition according to any one of claims 1 to 4, wherein the base oil (A) comprises at least a mineral oil (A1).

6. The lubricating oil composition according to any one of claims 1 to 5, wherein the base oil (A) has a kinematic viscosity at 40°C of 10 mm²/s or less.

7. The lubricating oil composition according to any one of claims 1 to 6, wherein the base oil (A) has a volume resistivity of 8.0×10¹⁰ Ω·m or more.

8. The lubricating oil composition according to any one of claims 1 to 7, wherein the lubricating oil composition is substantially free of water.

9. The lubricating oil composition according to any one of claims 1 to 8, wherein the lubricating oil composition has a kinematic viscosity at 40°C of 20 mm²/s or less.

10. The lubricating oil composition according to any one of claims 1 to 9, wherein the lubricating oil composition has a volume resistivity of 1.0×10⁸ Ω·m or more.

11. The lubricating oil composition according to any one of claims 1 to 10, wherein the lubricating oil composition is used for cooling an electrical apparatus.

12. The lubricating oil composition according to claim 11, wherein the electrical apparatus is a motor, a battery, an inverter, and an engine.

13. A cooling device for cooling an electrical apparatus, comprising the lubricating oil composition according to any one of claims 1 to 12 filled therein.

14. A method for using a lubricating oil composition, wherein the lubricating oil composition according to any one of claims 1 to 12 is applied to cooling of an electrical apparatus.

15. A method for producing the lubricating oil composition according to any one of claims 1 to 12, comprising a step of stirring at 10,000 rpm or more.
